(19) Europäisches Patentamt

European Patent Office

Office européen des brevets

(11) **EP 0 445 884 B1**

(12) **EUROPÄISCHE PATENTSCHRIFT**

(45) Veröffentlichungstag und Bekanntmachung des Hinweises auf die Patenterteilung:
**13.11.1996 Patentblatt 1996/46**

(51) Int Cl.6: **H03K 3/78**, H03K 3/64

(21) Anmeldenummer: **91200456.1**

(22) Anmeldetag: **04.03.1991**

(54) **Schaltungsanordnung zum Erzeugen einer vorgegebenen Anzahl Ausgangsimpulse**

Circuit arrangement for generating a predetermined number of output pulses

Montage pour générer un nombre prédéterminé d'impulsions de sortie

(84) Benannte Vertragsstaaten:
**CH DE FR GB IT LI**

(30) Priorität: **08.03.1990 DE 4007293**

(43) Veröffentlichungstag der Anmeldung:
**11.09.1991 Patentblatt 1991/37**

(73) Patentinhaber:
- **Philips Patentverwaltung GmbH**
  **22335 Hamburg (DE)**
  Benannte Vertragsstaaten:
  **DE**
- **Philips Electronics N.V.**
  **5621 BA Eindhoven (NL)**
  Benannte Vertragsstaaten:
  **CH FR GB IT LI**

(72) Erfinder: **Winter, Reinhold**
**W-5901 Wilnsdorf 1 (DE)**

(74) Vertreter: **Poddig, Dieter, Dipl.-Ing. et al**
**Philips Patentverwaltung GmbH,**
**Röntgenstrasse 24**
**22335 Hamburg (DE)**

(56) Entgegenhaltungen:
**US-A- 4 185 930**

- **PATENT ABSTRACTS OF JAPAN vol. 2, no. 154 (E-78)(9998) 25. Dezember 1978 & JP-A- 53 123 648**

**Beschreibung**

Die Erfindung betrifft eine Schaltungsanordnung zum Erzeugen einer vorgegebenen ersten Anzahl Ausgangsimpulse mit im wesentlichen untereinander gleichem Abstand zwischen jeweils zwei aufeinanderfolgenden Eingangsimpulsen mit variablem Abstand unter Steuerung von Taktimpulsen mit wenigstens kurzzeitig konstanter, aber wesentlich kleinerer Periodendauer als der Abstand der Ausgangsimpulse.

Eine derartige Schaltungsanordnung bildet im wesentlichen eine Frequenzvervielfachung und kann beispielsweise mittels einer phasengekoppelten Schleife aufgebaut werden, die einen spannungssteuerbaren Oszillator enthält, dessen Ausgangs impulse mittels eines Zählers durch die vorgegebene Anzahl geteilt und mit den Eingangsimpulsen phasenmäßig verglichen werden, wobei das Vergleichsergebnis über einen Tiefpaß die Frequenz des Oszillators steuert. Eine solche phasengekoppelte Schleife kann analog oder digital aufgebaut werden. Wenn dabei die Frequenz der Eingangsimpulse, d.h. der Abstand zweier aufeinanderfolgender Eingangsimpulse sich ändert, wird die Frequenz des Oszillators so nachgesteuert, daß die Anzahl der Ausgangsimpulse zwischen jeweils zwei Eingangsimpulsen wieder der vorgegebenen Anzahl entspricht. Dieses Nachregeln erfolgt jedoch durch die Wirkung des Tiefpasses verzögert, und die Gesamtanzahl der erzeugten Ausgangsimpulse zwischen mehreren aufeinanderfolgenden Eingangsimpulsen kann vorübergehend wesentlich von dem der vorgegebenen ersten Anzahl entsprechenden Wert abweichen, und zwar abhängig von dem Zeitverhalten der Änderung der Eingangsfrequenz und der Dimensionierung des Tiefpasses. In manchen Anwendungsfällen ist es jedoch erforderlich, daß die Anzahl der Ausgangs impulse möglichst schnell der vorgegebenen ersten Anzahl entspricht. Dieses Problem entsteht beispielsweise bei einem Matrixdrucker, der verschiedene Druckraster mit sehr hoher Wiederholgenauigkeit auch über die gesamte Druckbreite drucken soll. Für alle vorkommenden Druckraster muß dann ein gemeinsamer Teiler vorhanden sein, d.h. ein Taktsignal mit entsprechend hoher Frequenz, dessen einzelne Impulse möglichst exakt mit der Position des Druckkopfes verknüpft sind. Für eine hohe Plazierungsgenauigkeit der einzelnen Druckpunkte ist die Abtastung der Druckkopfposition unmittelbar am Druckkopf erforderlich, da sonst die Eigendynamik des Druckkopfantriebs unmittelbar die Genauigkeit negativ beeinflußt. Die direkte Erzeugung eines feinen Rastertaktes entsprechend dem gemeinsamen Teiler durch ein Abtastelement, das zusammen mit dem Druckkopf an einem entlang des horizontalen Druckweges angeordneten Lineal vorbeigeführt wird, ist technisch schwierig und sehr aufwendig. Die Abtastung der Druckkopfposition ist daher nur mit einer relativ groben Teilung sinnvoll. Aus diesen Rasterimpulsen grober Teilung müssen dann die entsprechenden Rasterimpulse feiner Teilung mit der durch den gemeinsamen Teiler geforderten Auflösung erzeugt werden. Diese Feinrasterimpulse müssen bezüglich der Position und vor allem bezüglich der Gesamtanzahl eine hohe Genauigkeit und eine sehr feste Verkopplung mit der groben Teilung aufweisen, damit in aufeinanderfolgenden Druckzeilen die Druckpositionen bezogen auf den Druckanfang möglichst genau übereinstimmen.

Aufgabe der Erfindung ist es, eine Schaltungsanordnung der eingangs genannten Art anzugeben, die auch bei größeren Schwankungen der Abstände der Eingangsimpulse möglichst schnell, d.h. möglichst am Ende der Eingangsimpulsperiode, die der Änderung folgt, die Gesamtanzahl der Ausgangsimpulse entsprechend der vorgegebenen ersten Anzahl genau erzeugt.

Diese Aufgabe wird erfindungsgemäß gelöst durch ein erste Zählanordnung, die die Taktimpulse zählt und bei jedem Eingangsimpuls zurückgesetzt wird und einen durch die erste Anzahl geteilten Zählwert abgibt, ein Register, das den geteilten Zählwert empfängt und mit jedem Eingangsimpuls vor dem Rücksetzen der ersten Zählanordnung übernimmt, eine zweite Zählanordnung, die die Taktimpulse zählt und beim Erreichen einer Endstellung ein Übertragssignal abgibt, und die mit jedem Eingangsimpuls und mit jedem Übertragssignal auf einen Wert entsprechend dem Inhalt des Registers gesetzt wird, wobei die Ausgangsimpulse von den Übertragssignalen abgeleitet sind, eine dritte Zählanordnung, die die Übertragssignale zwischen zwei aufeinanderfolgenden Eingangsimpulsen zählt und deren Anzahl mit der ersten Anzahl vergleicht und bei Gleichheit die Ableitung weiterer Ausgangsimpulse von den Übertragssignalen sperrt, und eine Korrektureinrichtung, die bei jedem Eingangsimpuls die Differenz zwischen der Anzahl der seit dem letzten vorhergehenden Eingangsimpuls gezählten Übertragssignale und der ersten Anzahl aufnimmt und zwischen die Übertragssignale eine der Differenz entsprechende Anzahl Impulse als zusätzliche Ausgangsimpulse einfügt.

Auf diese Weise werden nach jeder Änderung der Periodendauer zwischen zwei Eingangsimpulsen in der folgenden Periode die Ausgangsimpulse mit einem Abstand erzeugt, der unmittelbar genau der vorhergehenden Periode der Eingangsimpulse entspricht. Wenn allerdings aufeinanderfolgend eine fortschreitende Verkürzung der Eingangsimpulsperiode auftritt, d.h. der Abstand mehrerer jeweils aufeinanderfolgender Eingangsimpulspaare ist jeweils kürzer als der Abstand des vorhergehenden Eingangsimpulspaares, tritt allerdings zwangsläufig ein Übertrag auf die darauffolgende Eingangsimpulsperiode auf. In jedem Falle wird der Ausgleich der Anzahl Ausgangsimpulse in der kürzestmöglichen Zeit erreicht.

Zwar tritt dabei vorübergehend eine Ungleichverteilung der Ausgangsimpulse auf, jedoch ist diese unvermeidbar, da zu Beginn jeder Periode die Abstände der Ausgangs impulse von der vorhergehenden Periode abhängen, da die Länge der gerade begonnenen Periode noch nicht bekannt sein kann. Dies gilt grundsätzlich auch bei einer Verlängerung der Periode der Eingangsimpulse, wobei dann am Ende der Periode eine Lücke in den Ausgangsimpulsen entsteht. Besonders bei dem eingangs genannten Fall der Feinrastererzeugung für einen Drucker kommt es jedoch vor allem darauf an, daß die Gesamtzahl der Feinrasterimpulse bezogen auf den Druckanfang bei einer bestimmten Druckkopfposition genau reproduzierbar ist und keine aufakkumulierenden Fehler entstehen, da kurzzeitige Abweichungen in der Gleichverteilung der Feinrasterimpulse sich auf das Druckbild nicht auswirken, da der Feinrasterabstand ohnehin kleiner ist als die Abmessung des Druckpunktes.

Um bei kleinen bzw. langsamen Änderungen der Periode der Eingangsimpulse eine gewisse Reserve zu behalten und nicht unnötig oft Ausgangsimpulse auf die folgende Periode zu übertragen, ist es zweckmäßig, daß die zweite Zählanordnung jeweils zwischen dem Setzen und der Endstellung einen Taktimpuls weniger zählt, als dem Inhalt des Registers entspricht. Dadurch entsteht zwar im Normalfall, d.h. bei konstanter Periodendauer der Eingangsimpulse, am Ende jeweils eine kleine Lücke bzw. Ungleichverteilung der Ausgangsimpulse, aber dies ist z.B. bei dem beschriebenen Beispiel des Feinrasters für einen Drucker im Druckbild nicht sichtbar und im übrigen auch reproduzierbar. Eine geringe Verkürzung der Periodendauer der Eingangsimpulse führt dann lediglich nahezu zum Verschwinden dieser Lücke, ohne daß dann bereits Ausgangsimpulse auf die folgende Periode übertragen werden müssen.

Das Teilen des Zählwertes der ersten Zählanordnung kann auf verschiedene Weise durchgeführt werden. Eine besonders zweckmäßige Ausgestaltung der Erfindung, bei der auch die Vorgabe der ersten Anzahl sehr leicht geändert werden kann, ist dadurch gekennzeichnet, daß die erste Zählanordnung einen ersten Zähler, der die Taktimpulse zählt und mit jedem Eingangsimpuls und mit jedem Übertragssignal beim Erreichen einer Endstellung auf eine Stellung entsprechend der ersten Anzahl gesetzt wird, und einen zweiten Zähler enthält, der die Übertragssignale des ersten Zählers zählt, wobei die Stellung des zweiten Zählers den geteilten Zählwert der ersten Zählanordnung angibt. Dies stellt eine gewisse Aufteilung der für die Zählung der Taktimpulse erforderlichen Zählstufen dar, wobei ohne wesentlichen Mehraufwand unmittelbar der geteilte Zählwert entsteht. Da die erste Anzahl unmittelbar die Stellung des ersten Zählers bestimmt, auf die dieser periodisch gesetzt wird, läßt sich diese erste Anzahl auch leicht ändern.

Wenn die Periodendauer der Taktimpulse sehr viel kleiner ist als die Periodendauer der Ausgangsimpulse, wird also deren Periode sehr genau auf die entsprechende Teilung der Periode der Eingangsimpulse eingestellt. Wenn das Verhältnis dieser Periode jedoch nicht sehr groß ist, ist es nach einer weiteren Ausgestaltung der Erfindung zweckmäßig, daß der erste Zähler mit jedem Eingangsimpuls auf eine der halben ersten Anzahl entsprechende Stellung und mit jedem Übertragssignal dieses Zählers auf eine der ganzen ersten Anzahl entsprechende Stellung gesetzt wird. Dadurch ergibt sich automatisch eine Aufrundung des im Register gespeicherten Wertes.

Um das Raster der erzeugten Ausgangsimpulse möglicht konstant im Verhältnis zu den Eingangsimpulsen zu halten, ist es nach einer weiteren Ausgestaltung zweckmäßig, daß der zweite Zähler mit jedem Eingangsimpulse auf eine Anfangsstellung zurückgesetzt wird.

Um die zusätzlichen Ausgangsimpulse zu erzeugen, ist die Korrekturanordnung nach einer weiteren Ausgestaltung der Erfindung dadurch gekennzeichnet, daß die Korrekturanordnung die Übertragssignale der zweiten Zählanordnung empfängt und nach jeweils einer vorgegebenen zweiten Anzahl Übertragssignalen einem in der Korrekturanordnung enthaltenen Zeitglied) ein Auslösesignal zuführt, wobei das Zeitglied nach einer vorgegebenen Zeitspanne einen zusätzlichen Ausgangsimpuls erzeugt, und daß ein dritter Zähler die Anzahl der zusätzlichen Ausgangsimpulse zählt und mit der Differenz vergleicht und bei Gleichheit die weitere Erzeugung von zusätzlichen Ausgangsimpulsen sperrt. Das Zeitglied kann dabei zweckmäßig als weiterer Zähler ausgebildet sein, der durch das Auslösesignal auf einen Anfangswert zurückgesetzt und mit den Taktimpulsen bis auf eine Endstellung gezählt wird, bei der der zusätzliche Ausgangsimpuls erzeugt wird. Die vorgegebene zweite Anzahl kann im übrigen auch 1 sein, so daß die zusätzlichen Ausgangsimpulse in der folgenden Periode bei jedem von einem Übertragssignal abgeleiteten Ausgangsimpuls erzeugt werden. Dadurch wird die Korrektur bei einer starken Verkürzung der Eingangsimpulsperiode möglichst schnell durchgeführt, allerdings auf Kosten der Gleichverteilung.

Ausführungsbeispiele der Erfindung werden nachstehend anhand der Zeichnung näher erläutert. Es zeigen

Fig. 1    ein Blockschaltbild einer erfindungsgemäßen Anordnung,

Fig. 2    ein Zeitdiagramm der Signale verschiedener Punkte im Blockschaltbild nach Fig. 1,

Fig. 3    ein Blockschaltbild eines Beispiels einer Korrekturanordnung,

Fig. 4    eine andere Ausführung einer erfindungsgemäßen Anordnung,

Fig. 5    ein Zeitdiagramm der Signale verschiedener Punkte im Blockschaltbild nach Fig. 4,

Fig. 6    den genaueren Aufbau des ersten Zählers darin.

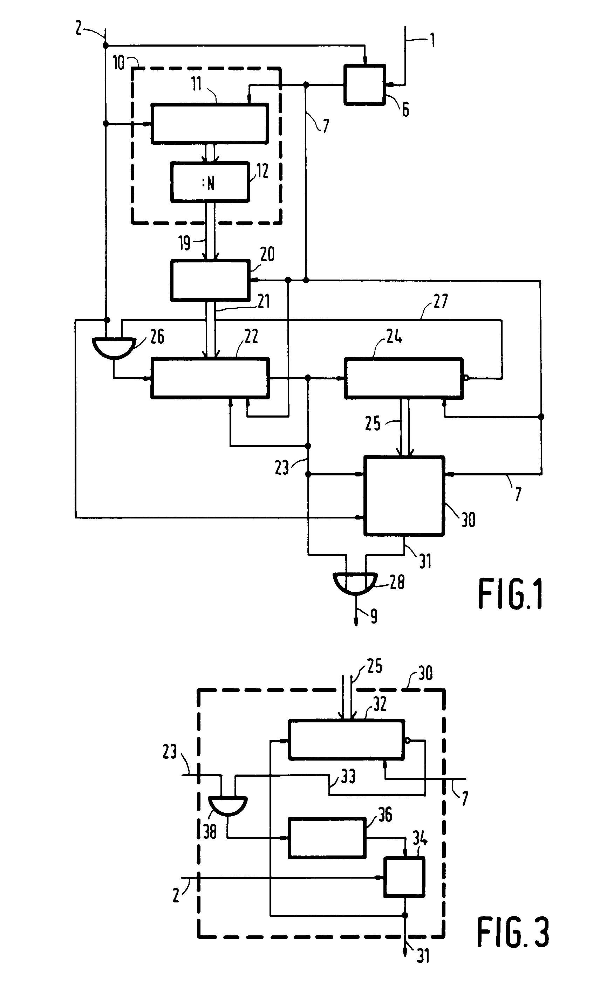

Bei der in Fig. 1 als Blockschaltbild dargestellten Anordnung werden einem Eingang 1 Eingangsimpulse zugeführt, wobei zeitlich zwischen diesen Eingangsimpulsen eine vorgegebene Anzahl N von Ausgangspulsen am Ausgang 9 erzeugt werden soll. Die Steuerung der einzelnen Elemente der Anordnung erfolgt mit Hilfe von Taktimpulsen, die über eine Leitung 2 von einem nicht näher dargestellten Taktimpulsgenerator zugeführt werden. Da die dem Eingang 1 zugeführten Eingangsimpulse keine eindeutige Phasenbeziehung zu den Taktimpulsen haben können und auch länger sind als ein Taktimpuls, werden die Eingangsimpulse einer Anordnung 6 zugeführt, in der aus jedem Eingangsimpuls mit Hilfe der Taktimpulse auf der Leitung 2 ein interner Eingangsimpuls auf der Leitung 7 erzeugt wird, der nur eine Taktimpulsperiode lang ist. Für die aufeinanderfolgende Steuerung verschiedener Elemente bei jedem Eingangsimpuls kann es auch zweckmäßig sein, zwei oder mehrere interne Eingangsimpulse abzuleiten, was für das Prinzip der Erfindung jedoch nicht von Bedeutung ist.

Die Anordnung in Fig. 1 enthält eine Zählanordnung 10 mit einem Zähler 11, der am Zähleingang ständig die Taktimpulse auf der Leitung 2 erhält. Mit jedem internen Eingangsimpuls auf der Leitung 7 wird der Zähler 11 auf die Nullstellung zurückgesetzt, so daß die Zählerstellung stets die Anzahl Taktimpulse seit dem letzten internen Eingangsimpuls angibt. Die Zählerstellung wird in einer Anordnung 12 durch die vorgegebene Anzahl N Ausgangsimpulse, die zwischen zwei Eingangsimpulsen erzeugt wird, geteilt, und der geteilte Wert wird parallel über die Verbindung 19 abgegeben.

Mit dem nächsten internen Eingangsimpuls auf der Leitung 7 wird dieser geteilte Zählwert in ein Register 20 eingeschrieben und über die Verbindung 21 dem parallelen Eingang eines weiteren Zählers 22 zugeführt, und er ist gleich der Anzahl Taktimpulse zwischen den letzten beiden Eingangsimpulsen, geteilt durch die vorgegebene erste Anzahl N.

Der Zähler 22 empfängt über ein UND-Glied 26, das zunächst über die Leitung 27 freigegeben ist, die Taktimpulse auf der Leitung 2 am Zähleingang, und außerdem wird der Zähler 22 mit jedem internen Eingangsimpuls auf der Leitung 7 sowie außerdem mit jedem von ihm selbst auf der Leitung 23 erzeugten Übertragssignal auf eine Stellung gesetzt, die dem Wert auf der Verbindung 21 entspricht. Diese Zählerstellung kann der Wert auf der Verbindung 21 direkt sein, wenn der Zähler 22 rückwärts zählt, wobei der Übertragsimpuls bei der Nullstellung erzeugt wird, oder der Zähler 22 wird auf das Komplement des Wertes auf der Verbindung 21 gesetzt und zählt aufwärts, bis er den Maximalwert erreicht, wobei dann das Übertragssignal erzeugt wird.

Wenn die Periode der Eingangsimpulse über mindestens zwei Perioden konstant ist, entstehen auf der Leitung 23 die gewünschten Ausgangsimpulse, wie nachstehend erläutert wird.

Wenn $f_c$ die Frequenz der Taktimpulse auf der Leitung 2 und $f_e$ die Frequenz der Eingangsimpulse ist, ergibt sich der Wert W auf der Verbindung 21 als

$$W = \frac{f_c}{f_e} \cdot \quad (1)$$

Durch das periodische Setzen des Zählers 22 auf den Wert W entsteht also als Übertragssignal auf der Leitung 23 die durch den Wert W geteilte Frequenz der Taktimpulse, wobei für W der vorher angegebene Ausdruck eingesetzt werden kann

$$\frac{f_c}{W} = f_c \cdot \frac{f_e \cdot N}{f_c} \quad (2)$$

Daraus ergibt sich, daß auf der Leitung 23 die Frequenz $f_a$ der Ausgangsimpule die der vorgegebenen ersten Anzahl N entsprechende Vielfache der Frequenz der Eingangsimpulse ist

$$f_a = f_e \cdot N \quad (3)$$

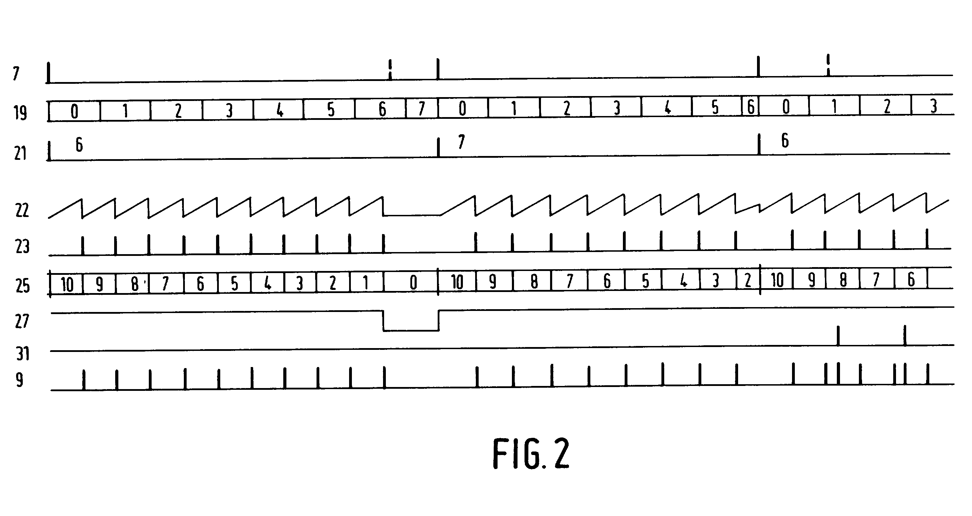

Dies soll nachfolgend noch näher anhand der Fig. 2, die ein Zeitdiagramm einiger Signale der Schaltung nach Fig. 1 zeigt, erläutert werden. Darin entsprechen die Zahlen der einzelnen Zeilen den Leitungen bzw. Elementen mit gleichen Bezugszeichen.

Das Zeitdiagramm umfaßt drei aufeinanderfolgende interne Eingangsimpulse mit unterschiedlichen Abständen, die in Fig. 2 in der Zeile 7 als ausgezogene Striche dargestellt sind, da von einer Frequenz der Taktimpulse ausgegangen wird, bei der die einzelnen Impulse zeichnerisch nicht mehr aufgelöst werden können, und jeder Impuls in der Zeile 7 sowie auch in den Zeilen 21, 23, 31 und 9 hat die Dauer eines Taktimpulses. In Zeile 7 sind gestrichelt noch die Zeitpunkte angedeutet, an denen ein interner Eingangsimpuls auftreten würde, wenn sich die Periode gegenüber der vorhergehenden Periode der Eingangsimpulse nicht geändert hätte.

Mit jedem internen Eingangsimpuls wird der Zähler 11 auf die Anfangsstellung zurückgesetzt und beginnt, die Taktimpulse auf der Leitung zu zählen. Am Ausgang 19 erscheinen dann die geteilten Zählerstellungen in binär codierter Form, die in Fig. 2 der Übersichtlichkeit halber dezimal angegeben sind.

Mit jedem internen Eingangsimpuls wird die in diesem Augenblick am Ausgang 19 vorhandene geteilte Zählerstellung in das Register 20 übernommen und erscheint am Ausgang 21. Wie aus Fig. 2 aus dem ersten gestrichelten Impuls in der Zeile 7 erkennbar ist, war am Ausgang 19 beim Eintreffen des ersten internen Eingangsimpulses ganz links diese geteilte Zählerstellung 6, und damit ist der Wert am Ausgang 21 des Registers 20 bis zum nächsten internen Eingangsimpuls 6, wie in Zeile 21 angegeben ist.

Der Zähler 22 zählt nun periodisch jeweils bis 6 und wird dann immer auf die Anfangsstellung zurückgesetzt, was in der Zeile 22 angedeutet ist. Bei jedem Zurücksetzen wird ein Übertragsimpuls erzeugt, der in Zeile 23 dargestellt ist.

Der Zähler 24 wird mit jedem internen Eingangsimpuls auf die der vorgegebenen Anzahl N = 10 entsprechende Stellung gesetzt und zählt mit jedem Übertragssignal in der Zeile 23 um eine Stellung zurück, bis die Stellung 0 erreicht ist. Mit dieser Stellung 0 wird das vom Zähler 24 erzeugte Signal auf der Leitung 27 niedrig und sperrt das UND-Glied 26, so daß der Zähler 22 nach dem Zurücksetzen in die Nullstellung beim letzten Übertragssignal in dieser Nullstellung verbleibt.

Die Zählerstellung 0 am Ausgang 25 des Zählers 24 wird mit dem nächsten Eingangsimpuls in die Korrekturanordnung 30 übernommen, so daß anschließend keine zusätzlichen Ausgangsimpulse erzeugt werden. Gleichzeitig geht der Ausgang 25 des Zählers 24 wieder auf die Stellung 10, damit wird das Signal auf der Leitung 27 wieder hoch, und der Zähler 22 kann wieder periodisch zählen.

Der zweite, in Fig. 2 dargestellte interne Eingangsimpuls ist jedoch später aufgetreten, als der vorhergehenden Periode der Eingangsimpulse entsprochen hätte, so daß vor dem Auftreten dieses verspäteten Eingangsimpulses eine gewisse Lücke in den Übertragssignalen der Zeile 23 und damit auch in den Ausgangsimpulsen in der Zeile 9, die unter diesen Bedingungen nur von den Übertragssignalen abgeleitet sind, auftritt. Gleichzeitig hat die Zählerstellung am Ausgang 19 den Wert 7 erreicht, so daß nunmehr für die nächste Periode der Wert 7 am Ausgang 21 entsteht und der Zähler periodisch nun jeweils bis 7 zählt. Dadurch haben die Übertragssignale in der Zeile 23 und damit auch die Ausgangssignale der Zeile 9 etwas größere Abstände.

Der nächste interne Eingangsimpuls, d.h. in Fig. 2 der dritte dargestellte Impuls, tritt nun wesentlich früher auf, als der vorhergehenden Periode entsprochen hätte, nämlich bereits nach dem achten Übertragssignal der Zeile 23, wo die Zählerstellung der Zeile 25 erst den Wert 2 erreicht hatte. Damit wird diese Zählerstellung in die Korrekturanordnung 30 übernommen, so daß also zwei zusätzliche Ausgangsimpulse in der nächsten Periode erzeugt werden müssen. Diese sind in der Zeile 31 dargestellt, wobei angenommen wird, daß nach jedem zweiten Übertragssignal ein zusätzlicher Ausgangsimpuls erzeugt wird. Die Impulse der Zeile 9 setzen sich also zusammen aus den Impulsen der Zeilen 23 und 31, und es ist zu erkennen, daß vorübergehend eine stärke Ungleichverteilung der Impulse auftritt, jedoch ist die Gesamtzahl der Ausgangsimpulse nach dem zweiten zusätzlichen Ausgangsimpuls bereits wieder so, wie sie bei Eingangsimpulsen mit konstanter Periode gewesen wäre.

Der dritte in Fig. 2 dargestellte interne Eingangsimpuls tritt übrigens auf, wenn die geteilte Zählerstellung am Ausgang 19 den Wert 6 erreicht hatte, so daß nunmehr wieder am Ausgang 21 für die folgende Periode der Wert 6 vorhanden ist und die Abstände der Übertragssignale kleiner ist als bei der vorhergehenden Periode, nämlich wie in der ersten dargestellten Periode.

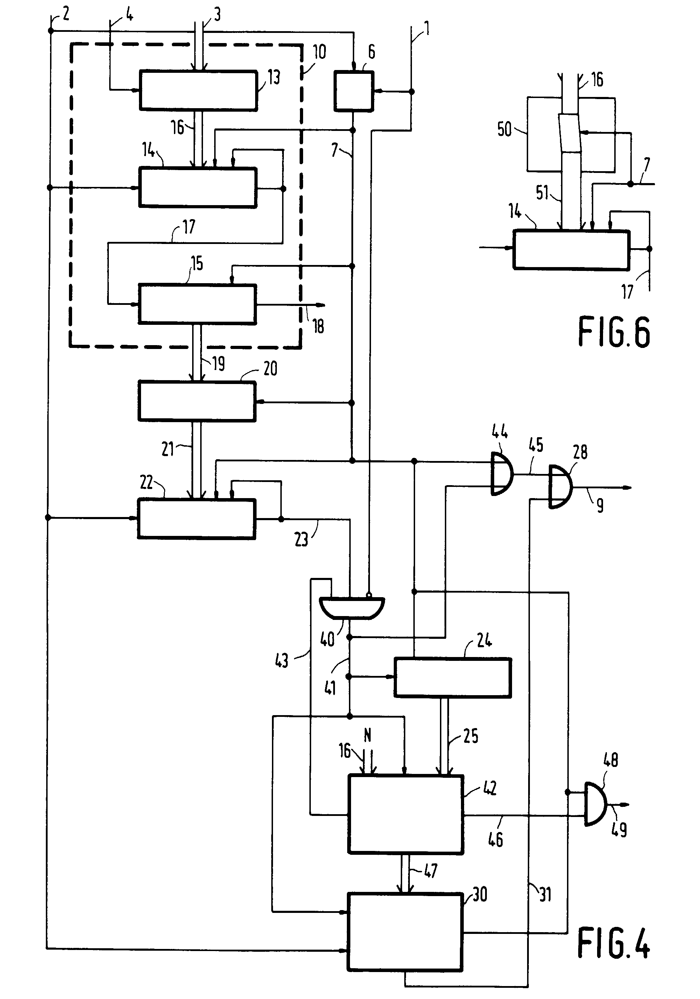

Ein möglicher Aufbau der Korrekturanordnung 30 der Fig. 1 ist in Fig. 3 dargestellt. Die Zählerstellung 25 am Ausgang des Zählers 24, die die noch möglicherweise fehlenden Ausgangsimpulse angibt, wird mit jedem internen Eingangsimpuls auf der Leitung 7 in einen Zähler 32 übernommen, der dadurch über die Leitung 33 ein UND-Glied 38 freigibt, so daß die Übertragssignale der Leitung 23 auf einen zyklisch zählenden Zähler 36 gelangen können. Nach einer Anzahl Übertragssignale auf der Leitung 23 entsprechend der Zykluszeit des Zählers 36 liefert dieser ein Auslösesignal an ein Zeitglied 34, das nach einer Zeitspanne, die kleiner ist als die kürzeste auftretende Periode der Übertragssignale auf der Leitung 23, aber länger als eine Periode der Taktimpulse, einen zusätzlichen Ausgangsimpuls auf der Leitung 31 abgibt, der gleichzeitig den Zähler 32 um eine Stellung zurückzählt. Sobald der Zähler 32 seine Nullstellung erreicht hat, wird über die Leitung 33 das UND-Glied 38 gesperrt, so daß keine weiteren zusätzlichen Ausgangsimpulse erzeugt werden können.

Das Zeitglied 34 kann zweckmäßig als Zähler ausgebildet sein, der durch jedes Auslösesignal vom Zähler 36 auf eine Anfangsstellung gesetzt wird und dann die Taktimpulse auf der Leitung 2 bis zu einer vorgegebenen Endstellung zählt, bei der der zusätzliche Ausgangsimpuls abgegeben wird und in der er verharrt, bis er wieder durch ein Auslösesignal zurückgesetzt wird.

Der Zähler 36 kann auch weggelassen werden, so daß nach jedem Übertragssignal auf der Leitung 23 ein zusätzlicher Ausgangsimpuls erzeugt wird.

In Fig. 4 ist eine Abwandlung der in Fig. 1 gezeigten Zeichnung dargestellt, wobei entsprechende Schaltungsteile mit den gleichen Bezugszeichen bezeichnet sind. Die erste Zählanordnung 10 enthält hier ein Register 13, in das ein über einen Eingang 3 zugeführter Wert, der die Anzahl N zu erzeugender Ausgangsimpulse zwischen jeweils zwei Eingangsimpulsen angibt, mit Hilfe eines Schreibimpulses über einen Eingang 4 eingeschrieben wird. Der Wert N am Ausgang 16 wird einem Zähler 14 zugeführt, der die Taktimpulse auf der Leitung 2 zählt. Mit jedem internen Eingangsimpuls auf der Leitung 7, der wieder in der Anordnung 6 aus dem externen Eingangsimpuls auf der Leitung 1 mit Hilfe der Taktimpulse auf der Leitung 2 erzeugt wird, wird der Zähler 14 auf eine Stellung gesetzt, die dem halben Wert N am Ausgang 16 entspricht. Dies kann beispielsweise in der Weise erfolgen, wie in Fig. 6 dargestellt, d. h. den parallelen Setzeingängen 51 des Zählers 14 ist ein Multiplexer 50 vorgeschaltet, der die parallelen Leitungen des Ausgangs 16 mit den Eingängen für die Bits geringster Wertigkeit des Zählers 14 verbindet und den am Ausgang 16 vorhandenen Wert komplementär in diesen Zähler einschreibt, der dann aufwärts zählt bis zur Endstellung. Bei dieser Endstellung wird am Übertragsausgang 17 ein Signal erzeugt, der den am Setzeingang anliegenden Wert wieder in den Zähler einschreibt, wobei nun jedoch der Multiplexer umgeschaltet ist, so daß die parallelen Leitungen des Ausgangs 16 um eine Stellung verschoben mit den Setzeingängen verbunden sind, so daß der Zähler nun jeweils die doppelte Anzahl Taktimpulse bis zum Erreichen der Endstellung zählt.

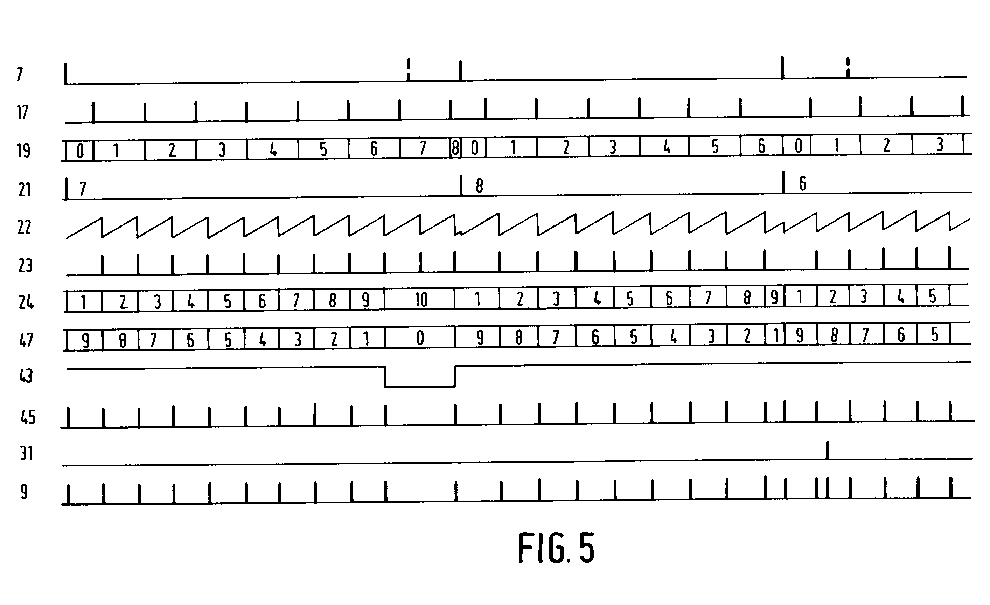

Dies ist in dem Zeitdiagramm der Fig. 5 dargestellt, wo wieder die einzelnen Zeilen mit den Zahlen bezeichnet sind, die die Bezugszeichen der Leitungen oder Elemente sind, an denen die im Zeitdiagramm dargestellten Signale auftreten. Der Abstand vom ersten internen Eingangsimpuls auf der Zeile 7 bis zum ersten Übertragssignal auf der Zeile 17 ist nur halb so lang wie die Abstände der folgenden Übertragssignale.

Die Übertragssignale auf der Leitung 17 werden ferner dem Zähleingang eines weiteren Zählers 15 zugeführt, der mit jedem internen Eingangsimpuls auf der Leitung 7 auf die Anfangsstellung zurückgesetzt wird. Am Ausgang 19 des Zählers 15 und damit der Zählanordnung 10 entstehen nun also Zählerstellungen, die in Fig. 5 in Zeile 19 angegeben sind. Die verkürzte erste Zählperiode des Zählers 14 ergibt also eine Aufrundung der vom Zähler 15 innerhalb einer Periode zwischen zwei Eingangsimpulsen erzeugten Zählerstellung.

Diese Zählerstellung am Ausgang 19 wird mit dem nächsten internen Eingangsimpuls auf der Leitung 7 wieder in das Register 20 eingeschrieben und erscheint dann am Ausgang 21. Für die Erläuterung der Fig. 5 wird zunächst angenommen, daß in der vorhergehenden Periode der Wert 7 in das Register 20 eingeschrieben wurde.

Es sei bemerkt, daß im vorliegenden Beispiel dadurch, daß in den Zähler 14 beim periodischen neuen Setzen durch die Übertragsimpulse auf die durch den Multiplexer 50 verschobene Stellung auf der Leitung 17 tatsächlich die Impulse in der halben Frequenz auftreten wie bei dem unverschobenen Setzen, so daß der Zähler 15 nur nach dem ersten Übertragsimpuls die halbe Frequenz zählt und die Stellung am Ausgang 19 eigentlich nur etwa halb so groß ist wie bei unverschobenem Setzen des Zählers 14, jedoch läßt sich dieser Faktor 2 durch eine entsprechende Stellenverschiebung an irgendeiner Stelle, beispielsweise auch beim Einschreiben in das Register, korrigieren, wenn nicht zunächst mit der doppelten Frequenz der Ausgangsimpulse gearbeitet werden soll, die dann an passender Stelle halbiert wird.

Der Zähler 22 wird nun durch jeden internen Eingangsimpuls auf der Leitung 7 und durch jeden übertragsimpuls 23 auf die am Ausgang 21 des Registers vorhandene Stellung gesetzt, jedoch wird der Übertragsimpuls bereits eine Stellung vor der Endstellung abgegeben. Auf diese Weise wird jede Periode des Zählers 22 gegenüber einer nominellen Periode verkürzt, die bei konstanter Periode der Eingangsimpulse weitgehend eine Gleichverteilung der Übertragssignale ergibt, und zwar um eine Taktimpulsdauer, so daß die Ausgangsimpulse etwas dichter erzeugt werden als der Periode entspricht und der letzte Ausgangsimpuls jeder Periode der Eingangsimpulse eine entsprechend frühere Zeit vor diesem nächsten Eingangsimpuls erzeugt wird, so daß am Ende jeweils eine Lücke entsteht, jedoch wird dann bei einer geringen Verkürzung der Periode der Eingangsimpulse nicht gleich das Erzeugen von zusätzlichen Ausgangsimpulsen erforderlich.

Die Ausgangsimpulse auf der Leitung 23 werden nun einem Eingang eines UND-Gliedes 40 zugeführt, das an einem weiteren Eingang ein Freigabesignal über die Leitung 43 erhält, dessen Erzeugung später angegeben wird, sowie über einen weiteren Eingang während der Dauer eines externen Eingangsimpulses gesperrt wird. Die Ausgangsleitung 41 des UND-Gliedes 40 ist nämlich mit dem einen Eingang eines ODER-Gliedes 44 verbunden, dessen anderer Eingang den internen Eingangsimpuls empfängt, so daß auf dessen Ausgangsleitung 45 mit jedem internen Eingangsimpuls und dann mit den folgenden Übertragssignalen auf der Leitung 23 jeweils ein Impuls entsteht, wie in Fig. 5 in der Zeile 45 angegeben ist. Das Sperren des UND-Gliedes 40 durch den externen Eingangsimpuls geschieht aus Gründen der sicheren Synchronisation.

Die Leitung 41 ist ferner mit dem Zähleingang eines Zählers 24 verbunden, der mit jedem internen Eingangsimpuls auf die Stellung 1 zurückgesetzt wird, da der Eingangsimpuls selbst bereits den ersten Ausgangsimpuls darstellt, und dann wird jedes auf der Leitung 23 erzeugte Übertragssignal vom Zähler 24 gezählt, wie in Zeile 24 in Fig. 5 angegeben ist. Die Zählerstellung am Ausgang 25 des Zählers 24 wird einem Subtrahierer 42 zugeführt, der diesen Wert von der vorgegebenen Anzahl N, die dem Subtrahierer 42 vom Ausgang 16 des Registers 13 zugeführt wird, subtrahiert. Am Ausgang 47 des Subtrahierers 42 wird die Differenz zwischen beiden Werten abgegeben, so daß also die in Zeile 47 angegebenen Werte auftreten.

Sobald der Subtrahierer 42 die Differenz 0 ermittelt, wird das UND-Glied 40 über die Leitung 43 gesperrt, und die weiter auftretenden Übertragssignale auf der Leitung 23 erscheinen nicht mehr auf der Leitung 41 bzw. der Leitung 45, und die dabei erreichte Stellung 10 des Zählers 24 bleibt erhalten.

In Fig. 5 ist zu erkennen, daß bei einem neuen internen Eingangsimpuls, der entsprechend der vorhergehenden Periode auftreten würde und der in Fig. 5 in der Zeile 7 gestrichelt dargestellt ist, der nächste Impuls auf der Leitung 45 und damit der nächste Ausgangsimpuls am Ausgang 9 ungefähr im gleichen Abstand wie die vorhergehenden entsprechenden Impulse aufgetreten wäre, so daß sich bei konstanter Periode der Eingangs impulse eine weitgehende Gleichverteilung ergibt.

Tatsächlich tritt der nächste interne Eingangsimpuls, d.h. der zweite in Zeile 7 angegebene Impuls, verzögert auf, wie dies auch in Fig. 2 angegeben ist. Bei diesem Eingangsimpuls hat der Ausgang 19 gerade den Wert 8 angenommen, so daß dieser Wert nun in das Register 20 eingeschrieben wird und am Ausgang 21 erscheint. Ferner wird der Zähler 22 wieder auf 0 zurückgesetzt, der Zähler 24 wird auf die Stellung 1 gesetzt, und auf der Leitung 45 erscheint wieder der erste Impulse der Ausgangsimpulse für die nächste Periode der Eingangsimpulse.

Die nächsten Übertragssignale auf der Leitung 23 und damit die Ausgangsimpulse auf der Leitung 45 bzw. dem Ausgang 9 treten nun in einem etwas größeren Abstand auf, entsprechend der verlängerten vorhergehenden Periode, die den Wert 8 am Ausgang 21 ergeben hat.

Der dritte in Fig. 5 dargestellte Eingangsimpuls tritt nun wieder wie in Fig. 2 nach einer verkürzten Periode der Eingangsimpulse auf, bevor der Zähler 24 die Stellung 10 und damit der Subtrahierer 42 am Ausgang 47 die Stellung 0 erreicht hat, sondern es ist noch der Wert 1 als Differenz vorhanden. Dieser Wert wird nun mit diesem internen Eingangsimpuls in die Korrekturanordnung 30 übernommen, und gleichzeitig wird der Wert 6, der in diesem Augenblick am Ausgang 19 vorhanden ist, in das Register 20 übernommen, und ferner wird der Zähler 22 auf 0 und der Zähler 24 auf 1 gesetzt, und es wird wieder ein Impuls auf der Leitung 45 erzeugt. Die weiteren Vorgänge laufen entsprechend den vorhergehenden Perioden ab, wobei nach dem ersten Übertragssignal auf der Leitung 23 von der Korrekturanordnung 30 ein zusätzlicher Ausgangsimpuls auf der Leitung 31 erzeugt wird, der dann am Ausgang 9 erscheint. Die Korrekturanordnung 30 kann dabei wie anhand der Fig. 3 erläutert aufgebaut sein.

Wie ein Vergleich der Fig. 2 und 5 zeigt, ist die Verteilung der Ausgangsimpulse am Ausgang 9 in Fig. 5 etwas gleichmäßiger, und es wird nur ein zusätzlicher Ausgangsimpuls erzeugt, trotz der wesentlichen Verkürzung der Periode der Eingangsimpulse.

In dem Blockschaltbild in Fig. 4 sind noch zwei Ausgänge 18 und 49 angegeben, auf denen bei bestimmten Fehlerbedingungen Signale auftreten. Der Ausgang 18 ist der Übertragsausgang des Zählers 15, und darauf tritt ein Übertrag auf, wenn die Periode der Eingangsimpulse bei einem bestimmten Vorgabewert zu lang ist, d.h. die durch die Frequenz der Taktimpulse und die Kapazität des Zählers 15 vorgegebene maximale Dauer überschreitet.

Am Ausgang 46 des Subtrahierers 42 erscheint ein Signal, solange die Differenz zwischen der Anzahl in der jeweiligen Eingangssignalperiode erzeugten Ausgangsimpulse, die am Ausgang 25 des Zählers 24 erscheint, und der vorgegebenen Anzahl N einen vorgegebenen Wert überschreitet. Falls dieser Wert noch überschritten ist, während bereits der nächste interne Eingangsimpuls auf der Leitung 7 erscheint, wird das UND-Glied 48 freigegeben, und am Ausgang 49 erscheint ein Signal. Dieses gibt an, daß die Anzahl der zusätzlichen Ausgangsimpulse, die in der nächsten Periode erzeugt werden sollen, den vorgegebenen Wert überschreitet, d.h. die Periode der Eingangsimpulse hat sich zu stark verkürzt. Entsprechend kann ein weiteres, nicht dargestelltes Fehlersignal erzeugt werden, wenn sich die Periode der Eingangssignale zu stark verlängert, indem die Zeitdauer nach dem Auftreten des N-ten Ausgangsimpulses und dem nächsten internen Eingangsimpuls mit Hilfe der Taktimpulse überwacht wird.

## Patentansprüche

1. Schaltungsanordnung zum Erzeugen einer vorgegebenen ersten Anzahl (N) Ausgangsimpulse mit im wesentlichen untereinander gleichem Abstand zwischen jeweils zwei aufeinanderfolgenden Eingangsimpulsen mit variablem Abstand unter Steuerung von Taktimpulsen mit wenigstens kurzzeitig konstanter, aber wesentlich kleinerer Periodendauer als der Abstand der Ausgangsimpulse, <u>gekennzeichnet durch</u>

   eine erste Zählanordnung (10), die die Taktimpulse zählt und bei jedem Eingangs impuls zurückgesetzt wird und einen durch die erste Anzahl geteilten Zählwert (W) abgibt, ein Register (20), das den geteilten Zählwert empfängt und mit jedem Eingangsimpuls vor dem Rücksetzen der ersten Zählanordnung (10) übernimmt, eine zweite Zählanordnung (22), die die Taktimpulse zählt und beim Erreichen einer Endstellung ein Übertragssignal abgibt, und die mit jedem Eingangsimpuls und mit jedem Übertragssignal auf einen Wert entsprechend dem Inhalt des Registers (20) gesetzt wird, wobei die Ausgangsimpulse von den Übertragssignalen abgeleitet sind, eine dritte Zählanordnung (24), die die Übertragssignale zwischen zwei aufeinanderfolgenden Eingangsimpulsen zählt und deren Anzahl mit der ersten Anzahl vergleicht und bei Gleichheit die Ableitung weiterer Ausgangsimpulse von den Übertragssignalen sperrt, und eine Korrektureinrichtung (30), die bei jedem Eingangsimpuls die Differenz zwischen der Anzahl der seit dem letzten vorhergehenden Eingangsimpuls gezählten Übertragagssignalen und der ersten Anzahl aufnimmt und zwischen die Übertragssignale eine der Differenz entsprechende Anzahl Impulse als zusätzliche Ausgangsimpulse einfügt.

2. Schaltungsanordnung nach Anspruch 1, <u>dadurch gekennzeichnet</u>, daß die zweite Zählanordnung (22) jeweils zwischen dem Setzen und der Endstellung einen Taktimpuls weniger zählt, als dem Inhalt des Registers (20) entspricht.

3. Schaltungsanordnung nach Anspruch 1 oder 2, <u>dadurch gekennzeichnet</u>, daß die erste Zählanord-

nung (10) einen ersten Zähler (14), der die Taktimpulse zählt und mit jedem Eingangsimpuls und mit jedem Übertragssignal beim Erreichen einer Endstellung auf eine Stellung entsprechend der ersten Anzahl gesetzt wird, und einen zweiten Zähler (15) enthält, der die Übertragssignale des ersten Zählers (14) zählt, wobei die Stellung des zweiten Zählers (15) den geteilten Zählwert der ersten Zählanordnung (10) angibt.

4. Schaltungsanordnung nach Anspruch 3, dadurch gekennzeichnet, daß der erste Zähler (14) mit jedem Eingangsimpuls auf eine der halben ersten Anzahl entsprechende Stellung und mit jedem Übertragssignal dieses Zählers (14) auf eine der ganzen ersten Anzahl entsprechende Stellung gesetzt wird.

5. Schaltungsanordnung nach Anspruch 3 oder 4, dadurch gekennzeichnet, daß der zweite Zähler (15) mit jedem Eingangsimpuls auf eine Anfangsstellung zurückgesetzt wird.

6. Schaltungsanordnung nach einem der Ansprüche 1 bis 5, dadurch gekennzeichnet, daß die Korrekturanordnung (30) die Übertragssignale der zweiten Zählanordnung (22) empfängt und nach jeweils einer vorgegebenen zweiten Anzahl Übertragssignalen einem in der Korrekturanordnung (30) enthaltenen Zeitglied (34) ein Auslösesignal zuführt, wobei das Zeitglied (34) nach einer vorgegebenen Zeitspanne einen zusätzlichen Ausgangsimpuls erzeugt, und daß ein dritter Zähler (32) die Anzahl der zusätzlichen Ausgangsimpulse zählt und mit der Differenz vergleicht und bei Gleichheit die weitere Erzeugung von zusätzlichen Ausgangsimpulsen sperrt.

**Claims**

1. A circuit arrangement for generating a preset first number (N) of output pulses having a substantially equal interspacing between two consecutive input pulses having a variable interspacing under the control of clock pulses which have a cycle duration which is constant at least in the short term, but considerably smaller than the interspacing of the output pulses, characterized in that

   a first counter device (10), which counts the clock pulses, is reset at each input pulse and provides a count value (W) divided by the first number, a register (20) which receives the divided count value and stores it at each input pulse before the first counter device (10) is reset,

   a second counter device (22) which counts the clock pulses, provides a carry signal upon reaching an end position and is set at a value corresponding to the contents of the register (20) at each input pulse and at each carry signal, the output pulses being derived from the carry signals,

   a third counter device (24) which counts the carry signals between two consecutive input pulses and compares their number with the first number and blocks the derivation of further output pulses from the carry pulses in the case of equality, and

   a correction device (30) which at each input pulse receives the difference between the number of carry signals counted since the preceding input pulse and the first number, and inserts between the carry signals a number of pulses corresponding to the difference as additional output pulses.

2. A circuit arrangement as claimed in Claim 1, characterized in that the second counter device (22) counts one clock pulse less between the reset and the end position than corresponds to the contents of the register (20).

3. A circuit arrangement as claimed in Claim 1 or 2, characterized in that the first counter device (10) comprises a first counter (14), which counts the clock pulses and which is set for a position corresponding to the first number at each input pulse and at each carry signal upon reaching an end position, and a second counter (15) which counts the carry signals of the first counter (14), the position of the second counter (15) indicating the divided count value of the first counter device (10).

4. A circuit arrangement as claimed in Claim 3, characterized in that the first counter (14) is set for a position corresponding to half the first number at every input pulse and to a position corresponding to the whole first number at every carry signal of this counter (14).

5. A circuit arrangement as claimed in Claim 3 or 4, characterized in that the second counter (15) is reset to an initial position at every input pulse.

6. A circuit arrangement as claimed in any one of the Claims 1 to 5, characterized in that the correction device (30) receives the carry signals of the second counter device (22) and supplies a trigger signal to a time function element (34) incorporated in the correction device (30) each time after a given second number of carry signals, while the time function element (34) generates an additional output pulse after a given time interval, and in that a third counter (32) counts the number of additional output pulses, compares them with the difference, and blocks the further generation of additional output pulses in the case of equality.

## Revendications

1. Montage de circuit destiné à générer un premier nombre prédéterminé N d'impulsions de sortie séparées l'une de l'autre par un intervalle pratiquement semblable entre chaque fois deux impulsions d'entrée successives séparées par un intervalle variable sous la commande d'impulsions d'horloge de période au moins temporairement constante, mais sensiblement plus courte que l'intervalle séparant les impulsions de sortie, caractérisé par

un premier dispositif de comptage (10) qui compte les impulsions d'horloge, qui est remis à zéro à chaque impulsion d'entrée et qui délivre une valeur de comptage (W) divisée par le premier nombre, un registre (20) qui reçoit la valeur de comptage divisée et la prend en charge à chaque impulsion d'entrée avant la remise à zéro du premier dispositif de comptage (10), un deuxième dispositif de comptage (22) qui compte les impulsions d'horloge et délivre, lorsqu'une position finale est atteinte, un signal de report et qui, à chaque impulsion d'entrée et à chaque signal de report, est positionné à une valeur correspondant au contenu du registre (20), les impulsions de sortie étant dérivées des signaux de report,
un troisième dispositif de comptage (24) qui compte les signaux de report entre deux impulsions d'entrée successives et dont le nombre est comparé au premier nombre et, en cas d'égalité, bloque la dérivation d'autres impulsions de sortie des signaux de report et
un dispositif de correction (30) qui, à chaque impulsion d'entrée, enregistre la différence entre le nombre de signaux de report comptés depuis la dernière impulsion d'entrée précédente et le premier nombre et insère en tant qu'impulsions de sortie complémentaires entre les signaux de report un nombre d'impulsions correspondant à la différence.

2. Montage de circuit suivant la revendication 1, caractérisé en ce que le deuxième dispositif de comptage (22) compte, chaque fois entre le positionnement et la position finale, une impulsion d'horloge en moins que le contenu du registre (20).

3. Montage de circuit suivant la revendication 1 ou 2, caractérisé en ce que le premier dispositif de comptage (10) comprend un premier compteur (14) qui compte les impulsions d'horloge et qui, à chaque impulsion d'entrée et à chaque signal de report, une fois une position finale atteinte, est positionné à une position correspondant au premier nombre et un deuxième compteur (15) qui compte les signaux de report du premier compteur (14), la position du deuxième compteur (15) indiquant la valeur de comptage divisée du premier dispositif de comptage (10).

4. Montage de circuit suivant la revendication 3, caractérisé en ce que le premier compteur (14) est positionné, à chaque impulsion d'entrée, sur une position correspondant à la moitié du premier nombre et, à chaque signal de report de ce compteur (14), sur une position correspondant à la totalité du premier nombre.

5. Montage de circuit suivant la revendication 3 ou 4, caractérisé en ce que le deuxième compteur (15) est repositionné, à chaque impulsion d'entrée, sur une position de départ.

6. Montage de circuit suivant l'une quelconque des revendications précédentes, caractérisé en ce que le dispositif de correction (30) reçoit les signaux de report du deuxième dispositif de comptage (22) et achemine, après chaque fois un deuxième nombre prédéterminé de signaux de report, un signal de déclenchement à un élément de temporisation (34) contenu dans le dispositif de correction (30), l'élément de temporisation (34) générant, après un intervalle de temps prédéterminé, une impulsion de sortie supplémentaire, et en ce qu'un troisième compteur (32) compte le nombre d'impulsions de sortie supplémentaires, le compare à la différence et bloque, en cas d'égalité, la génération ultérieure d'impulsions de sortie supplémentaires.

FIG.1

FIG.3

FIG.2

EP 0 445 884 B1

FIG.6

FIG.4

FIG. 5

EP 0 445 884 B1